**Europäisches Patentamt**

(19) **European Patent Office**

**Office européen des brevets**

(11) Publication number: **0 126 611**

**B1**

(12) # EUROPEAN PATENT SPECIFICATION

(45) Date of publication of patent specification: **12.09.90**

(51) Int. Cl.⁵: **H 01 L 29/08**

(21) Application number: **84303272.3**

(22) Date of filing: **15.05.84**

(54) Thermal resistance of semiconductor devices.

(30) Priority: **16.05.83 JP 85363/83**

(43) Date of publication of application:
**28.11.84 Bulletin 84/48**

(45) Publication of the grant of the patent:
**12.09.90 Bulletin 90/37**

(84) Designated Contracting States:
**DE FR GB**

(56) References cited:
**EP-A-0 101 120**
**EP-A-0 115 650**
**EP-A-0 130 508**
**US-A-3 225 261**
**US-A-4 148 047**

**ELECTRONIC ENGINEERING, vol. 55, no. 674,
February 1983, page 15, Londen, GB: "Siliconix
undercuts power MOSFET industry"
IDEM**

(73) Proprietor: **FUJITSU LIMITED
1015, Kamikodanaka Nakahara-ku
Kawasaki-shi Kanagawa 211 (JP)**

(72) Inventor: **Kashiwagi, Shunji c/o Fujitsu Limited
Patent Dpt. 1015 Kamikodanaka Nakahara-ku
Kawasaki-shi Kanagawa 211 (JP)**

(74) Representative: **Sunderland, James Harry et al
HASELTINE LAKE & CO Hazlitt House 28
Southampton Buildings Chancery Lane
London WC2A 1AT (GB)**

(56) References cited:

**PROCEEDINGS OF THE INSTITUTE OF
ELECTRICAL AND ELECTRONIC ENGINEERS,
vol. 56, no. 4, April 1968, pages 742-743, IEEE,
New York, US; M. FUKUTA et al.: "Mesh emitter
transistor"**

**INTERNATIONAL ELECTRON DEVICES
MEETING, TECHNICAL DIGEST, Washington,
D.C., US, 5th-7th December 1983, pages 225-
228, IEEE, US; K. ISHII et al.: "A 900 MHz 100 W
CW mesh emitter type transistor with P.H.S.
structure"**

Courier Press, Leamington Spa, England.

## Description

The present invention relates to the thermal resistance of semiconductor devices. The present invention is particularly concerned with high frequency and high power semiconductor devices.

To achieve higher operating frequencies, semiconductor device size must be decreased, and so device output power goes down. In order to provide a high power output, therefore, it is usual to arrange many small devices (for example transistors) in parallel in a single chip. Such small elemental devices are arranged in a group and connected in parallel and, further, many such groups are connected in parallel in a single chip.

The terms "elemental chip", "unit cell", and "semiconductor device" used in the description hereinafter should be understood as follows: An "elemental cell" is an elemental device forming a bipolar transistor which is fabricated on a semiconductor substrate. In high frequency and high power transistors as described herin, a plurality of elemental cells (usually more than ten) are combined into a "unit cell". Further, a plurality of such unit cells (usually more than ten unit cells) are combined into a single "semiconductor device". In a single high frequency and high power transistor device, therefore, usually, more than a hundred (10×10) elemental cells are combined.

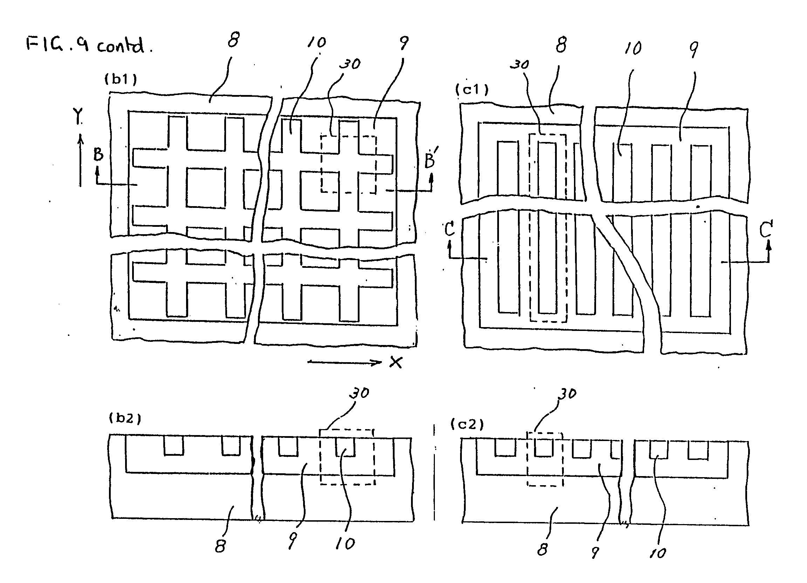

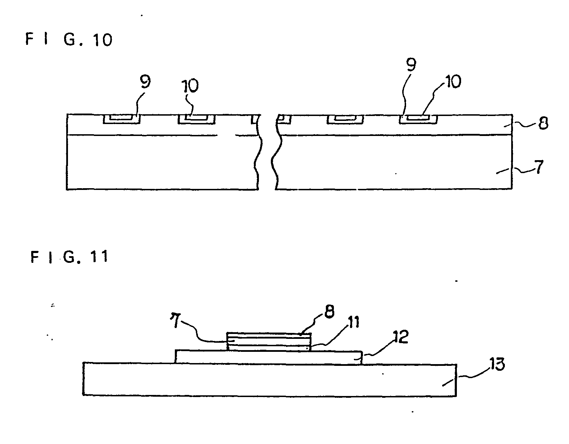

For example, in a high frequency and high power bipolar transistor, a plurality of emitter regions are fabricated in a base region and a plurality of such base regions are fabricated in a collector region. So, each emitter in a base region corresponds to an "elemental cell", a base region including a plurality of elemental cells (emitter regions) corresponds to a "unit cell", and the collector region including a plurality of unit cells corresponds to a "semiconductor device" (a transistor chip or die in this case). Therefore, a base region is a common region in a unit cell, and the collector region is a common region in the semiconductor device (transistor chip). Further details of such a structure will be explained later with reference to Figs. 9 and 10 of the accompanying drawings.

The following description will be given mainly with reference to bipolar transistors in order to simplify explanations.

To achieve a high frequency and high power semiconductor device a number of elemental cells having a same pattern are connected electrically in parallel. The requirement for the elemental cells to have the same pattern arises from a consideraion of interconnecting circuits provided between the unit cells. When the device is operated at a high frequency, if the unit cells were of a variety of shapes or patterns it would be difficult to maintain operating balance of the unit cells, causing unstable operation and low efficiency.

Furthermore, in a bipolar transistor semiconductor device it si essential to make the length of the periphery of an emitter region as long as possible in order to obtain a high current output, because the length of the emitter periphery determines the emitter current capacity.

A large amount of heat is generated from a small area, several mm² for example, in high power operation of a semiconductor device, so that the temperature of the device goes up very high.

It is necessary to reduce junction temperatures of unit cells as far as possible and to balance junction temperatures between the unit cells, to produce high power output in a high frequency region, but it is also required to avoid thermal runaway.

Generally, a semiconductor device has a tendency to fall into thermal runaway at high junction temperatures or with unbalanced junction temperature distributions. That is, junction current tends to increase as junction temperature rises, and the increased current causes a futher junction temperature rise. Once thermal runaway occurs, it causes degradation of transistor characteristics and can result in burn out problems.

In addition to preventing thermal runaway, reducing junction temperatures and balancing temperature distributions is desirable for other reasons: improvement of power output gain, high frequency characteristics, and transistor chip life.

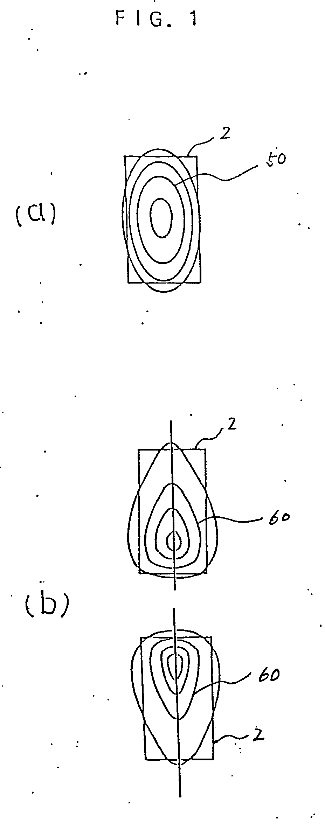

In a bipolar transistor, heat produced in the transistor is mainly generated at its base-collector junction (usually called the base junction). As mentioned above, in a single unit cell, many small emitter regions are fabricated on a base region, and so, as long as all elemental cells are operated uniformly, heat is generated uniformly in the whole area of the base region. Accordingly, temperature distribution over the base region is as shown in Fig. 1(a) of the accompanying drawings which is a schematic illustration of temperature distribution over a single base region, in which 50 is a constant temperature contour, and 2 is a unit cell. As indicated in the Figure, temperature is highest at a central part of the unit cell.

Thermal runaway tends to occur at a center part of device, because there temperature is highest. This tendency is more marked as the area of a unit cell becomes larger. If a high power semiconductor device had a structure consisting of a single unit cell having a large area, the amount of heat generated by the device would increase so much that the device could not maintain thermal and electrical balance, resulting in thermal runaway. Consequently, a high power and high frequency semiconductor device comprises a plurality of unit cells with relatively small area base regions (unit cells) distributed uniformly.

A high frequency and high power transistor chip is ususally mounted on a heat sink. Most of the heat generated at a base junction flows in a diverging fashion from the base pattern of a unit cell.

This means that the heat flow has flow-vector components both perpendicular and parallel to the base junction. Theoretical calculations of heat flow and temperature distribution can be handled by solving Poisson's equation. This is disclosed in, for example: D. P. Kennedy's "Spreading Resistance in Cylindrical Semicondoctors" by J. Appl. Phys., PP 1490—1496 (1960). However, the calculation involved for an actual semiconductor device is extremely complicated and would require use of a high speed large memory computer for a long period of time. Therefore, a simple approximation based on the concept of a thermal spreading angle has been generally applied for such calculation. This approximation is based on a solution of Poisson's equation, such that the major part of the heat flow from a base junction occurs within a zone bounded by the spreading angle which is determined from boundary conditions of the device. Using the concept of the spreading angle, the heat flow of semiconductor devices can be explained as set forth below.

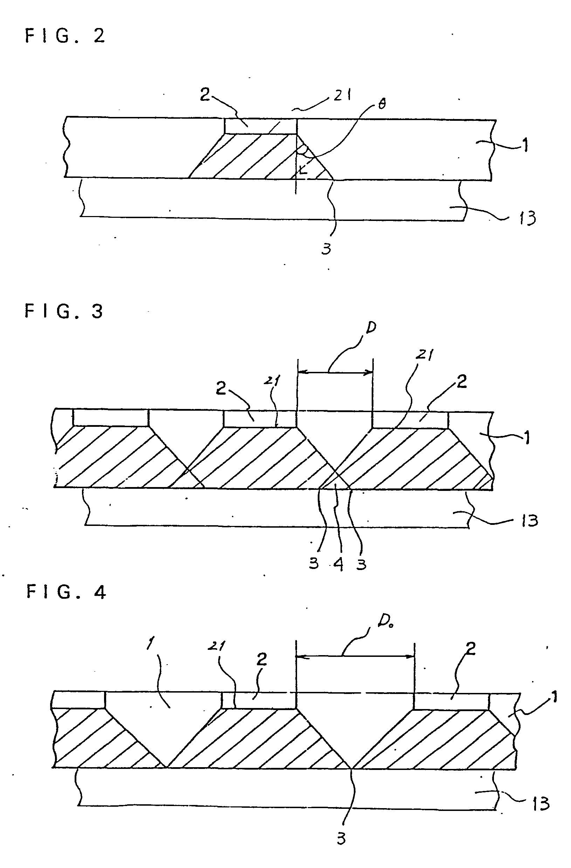

Figs. 2, 3 and 4 of the accompanying drawings are sectional views illustrating heat flows in semiconductor device substrates. In the Figures, 1 is a collector (substrate), 2 is a base region (unit cell), 21 is a base junction between base region 2 and collector region 1, and 13 is a heat sink. The heat generated at base junction 21 flows to the heat sink 13 through collector 1 in a divergent fashion so that the heat flux spreads to a flux edge 3 at the plane of heat sink 13 as shown in the Figures. The edge is determined from the spreading angle θ.

Fig. 2 illustrates heat flow from the base junction 21 to the heat sink 13 without taking into account any effects of heat flux from other unit cells. This corresponds to a temperature distribution on the chip surface as illustrated in Fig. 1(a). As the Figure shows, heat flows through the collector region 1 divergently as shown by the hatched region in the Figure.

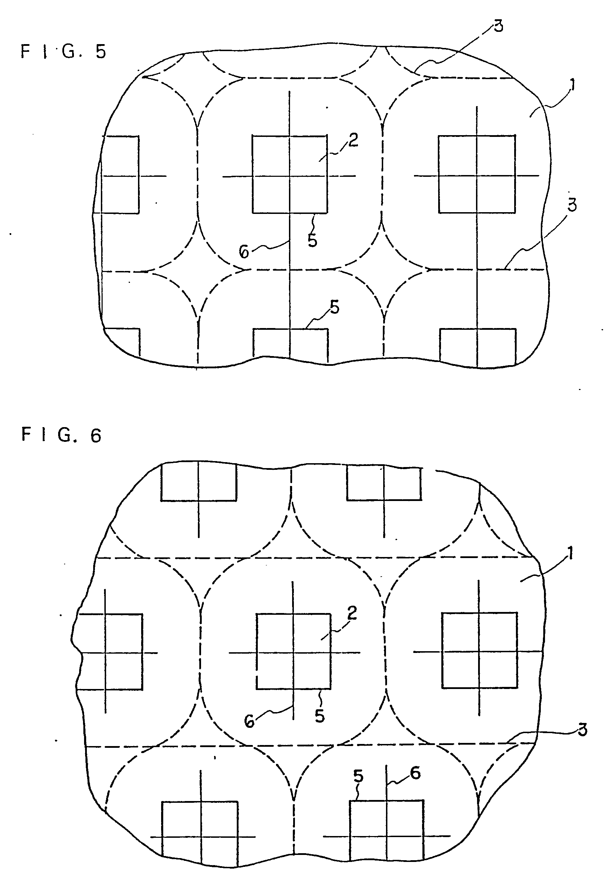

When a plurality of base regions 2 are arranged on the same collector 1, heat interaction occurs between them. This is illustrated in Fig. 3 in which heat fluxes from different base regions 2 interact with one another at heat flux overlap zones 4. The greater the extent of overlap zones 4, the greater is the thermal resistance of collector region 1 increases. This has the effect of raising the temperature of unit cells so that the contours of constant temperature of the cells lose symmetry. This is shown in Fig. 1(b) in which 60 is a constant temperature contour of one unit cell 2 and an adjacent cell. This loss of symmetry means that each base unit is led into unbalanced operation.

Therefore, in the previous technology, based on a consideration of heat spreading angle, it was considered that the base regions 2 of a plurality should be arranged so as to avoid the occurrence of heat flux overlap zones 4, but on the other hand they should be arranged as close as possible to each other in order to decrease the packing density of the device and to increase inductance and parasitic capacitance of interconnecting circuits on the chip surface and the wirings, in high frequency operation. This is shown in Fig. 4, in which the base regions are spaced apart at a minimum distance $D_0$ (larger than their spacing D in Fig. 3) which avoids the occurrence of overlap zones 4.

The heat spreading angle (θ) of heat flux as shown in Fig. 2 can be obtained experimentally by measuring the thermal resistance of a single unit cell, and generally has a value between 40 and 60 degrees. The concept of heat spreading angle has been applied well to the calculation of pattern pitch of unit cells in power transistors.

Previously, the C.W. output power of a single chip bipolar transistor has not been more than 50 W at 900 MHz, so far as the inventor knows. This value has been considered to be the practical limit for a high frequency and high power semiconductor single chip device.

Electronic Engineering, Vol. 55, February 1983, No. 674, page 15, is concerned with a guard ring structure for an MOSFET. Various source geometries are proposed, each with a grid of unit cells, including an offset square arrangement.

US—A—4 148 047 is concerned with the geometrical design of source and drain terminals of a field effect transistor device, for providing a relatively low "on" condition resistance. A hexagonal matrix structure is involved.

EP—A1—0 101 120 and EP—A—0 115 650, which are concerned with field effect transistors, form part of the state of the art by virtue of Article 54(3) EPC. A device according to the first part of claim 1 is known for instance from US—A—3 225 261.

According to the present invention there is provided a high-power and high-frequency semiconductor device forming a bipolar transistor, comprising:—

a semiconductor substrate;

a common collector region formed on a surface of said semiconductor substrate, said common collector region having a first conductivity type;

a plurality of base regions operatively connected in parallel, having a second conductivity type, opposite to the first conductivity type, each of said base regions being formed with a polygon shape on the surface of said semiconductor substrate in said common collector region, and

a plurality of emitter regions, operatively connected in parallel, having the first conductivity type, at least one of said emitter regions being formed in each of said base regions; characterised in that

the base regions are arranged in first and second parallel lines which lie alongside one another, with the base regions spaced apart one from the next at the same pitch in each of those lines, and in that the base regions in the first line are offset from the base regions in the second line.

An embodiment of the present invention can provide a semiconductor device with an improved temperature distribution and thermal resistance. Junction temperature of a high frequency and high power semiconductor device can be reduced.

An embodiment of the present invention can extend the practical limit of output power of high frequency and high power semiconductor devices.

An embodiment of the present invention can provide a bipolar transistor having the output power higher than the previous state-of-the-art transistor.

In an embodiment of the present invention a zig-zag arrangement of unit cells is employed, which representa an improvement over the previous orthogonal matrix arrangement, so that the substrate of the semiconductor device can offer a smaller thermal resistance without decrease in packing density.

The output power of the high frequency and high power single transistor chip can be increased, by employment of the present invention, to about twice that of the previous state-of-the-art transistor.

Reference is made, by way of example, to the accompanying drawings, in which:

Fig. 1 gives a schematic diagrams illustrating thermal distributions of unit cells of semiconductor devices, showing constant temperature contours, in which:—

diagram (a) shows temperature distribution over a unit cell not affected by other unit cells, and

diagram (b) shows temperature distribution over unit cells each affected by heat flow from a neighbouring unit cell;

Fig. 2 is a schematic sectional view of a semiconductor device substrate illustrating heat flow from a unit cell to a heat sink;

Fig. 3 is a schematic sectional view of a semiconductor device substrate illustrating heat flows from unit cells which are arranged so closely to one another that their heat fluxes overlap;

Fig. 4 is a schematic sectional cut view of a semiconductor device substrate illustrating heat flows from unit cells which are separated properly, so that their heat fluxes do not overlap;

Fig. 5 is a schematic plan view of an orthogonal matrix arrangement of unit cells as used in a previous high frequency and high power transistor;

Fig. 6 is a schematic plan view of a zig-zag arrangement of the unit cells employed in an embodiment of the present invention for a high frequency and high power transistor;

Fig. 7 is a schematic diagram showing constant temperature contours on the surface of a previous semiconductor device in which unit cells are arranged in an orthogonal matrix;

Fig. 8 is a schematic diagram showing constant temperature contours on the surface of a semiconductor device employing the present invention in which the unit cells are arranged in a zig-zag arrangement in accordance with the present invention;

Fig. 9 illustrates a transistor chip embodying the present invention with unit cells arranged in zig-zag pattern; In Fig. 9,

(a) is a plan view of the semiconductor device illustrating the zig-zag arrangement of unit cells which are square or recangular in shape,

(b1) is a plan view of a unit cell having a mesh type emitter, which can be applied for the unit cells in the device of Fig. 9(a);

(b2) is a sectional view of the unit cell of Fig. 9 (b1), taken along the line of B—B′ in Fig. 9(b1);

(c1) is a plan view of a unit cell having a parallel rectangular type emitter, which can be applied to the unit cells of the device of Fig. 9(a); and

(c2) is a sectional view of the unit cell of Fig. 9(c1) along the line of C—C′ in Fig. 9(c1);

Fig. 10 is a sectional view of the device substrate taken along the line A—A′ in Fig. 9(a), illustrating the internal structure of the semiconductor device embodying the present invention;

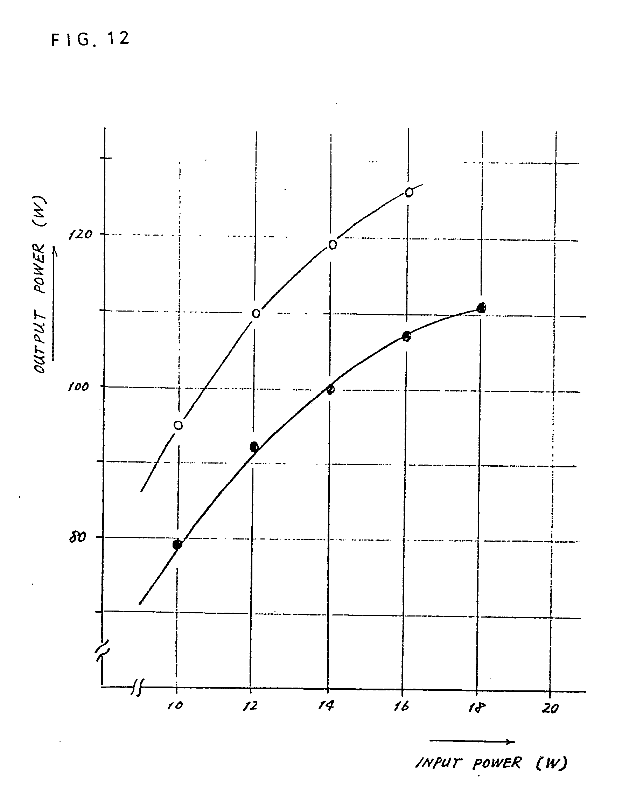

Fig. 11 is a sectional view illustrating the structure of the semiconductor device of Fig. 9(a) mounted on a heat sink;

Fig. 12 is a graph showing curves of C.W. output power with respect to the input power in 900 MHz for a transistor embodying the present invention and a previous transistor;

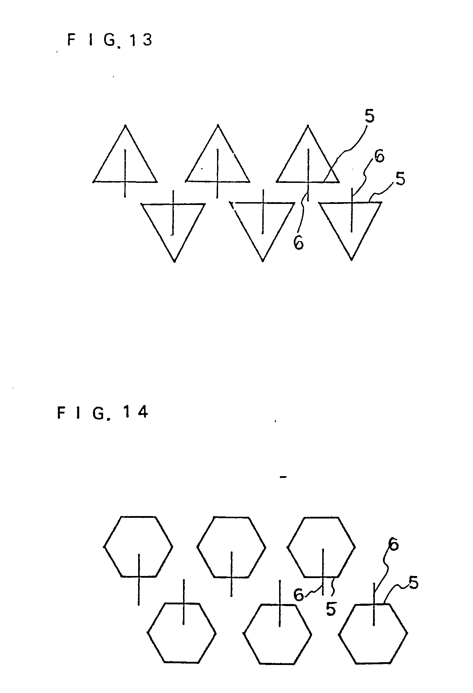

Fig. 13 is a schematic diagram illustrating the unit cell arrangement of an ambodiment of the present invention having triangular unit cells; and

Fig. 14 is a schematic diagram illustrating the unit cell arrangement of an embodiment of the present invention having hexagonal unit cells.

As mentioned above, a high frequency and high power transistor has a structure which has many emitter regions fabricated on a common base region, to form a unit cell, and many such unit cells are fabricated on a common collector region.

Such a structure is desirable for balancing load on elemental cells or unit cells to avoid thermal runaway, and in order to prevent thermal runaway the spacing between unit cells should be wide. However, wide spacing requires long interconnecting circuits on the chip surface which increases parasitic capacitance and inductance, also hence decreases output power gain of the transistor. Therefore, the technique used for spacing unit cells is very important for the design of the high frequency and high power transistors.

In the previously used spacing technology, unit cells are arranged in the form of an orthogonal matrix as illustrated in Fig. 5 which shows schematically a part of the surface of a previous high frequency and high power transistor. As shown in the Figure, the unit cells 2 are arranged like an orthogonal matrix. It was considered that the matrix arrangement was the best way to provide high frequency operation because the capacitance and the inductance of a lead pattern connecting the unit cells could be minimised, and furthermore it was also the best way to simplify the design of the unit cells and their wiring patterns.

Therefore, attention was concentrated on achieving decreased space between unit cells. Thermal flow considerations as described with resepct to Figs. 2, 3 and 4 were widely studied.

From measurements of temperature distribution on the surface of a chip, it has been found that a unit cell temperature is affected or changed partly in dependence upon heat flow from other unit cells even when heat flux overlap zones 4 (see Figs. 2, 3 and 4) are avoided from the point of view of a consideration of the thermal spreading angle. Thus it has been found that some heat flux exists even at a flow angle outside the thermal spreading angle. This becomes particularly important as operating power increases.

In study of thermal distribution on unit cells, it was found that with the previous unit cell arrangement as shown in Fig. 4 or 5, temperatures of some points on a unit cell easily rose and could sometimes cause hot spots to be produced. It was found impossible to avoid such hot spots in high power operations so long as the arrangement of the unit cells in Fig. 5 was used.

However, with a zig-zag arrangement in accordance with the present invention as shown in Fig. 6 the occurrence of hot spots is drastically decreased.

Fig. 6 is a plan view illustrating a zig-zag pattern of unit cells as employed in an embodiment of the present invention. In Fig. 6, 1 is a collector region (substrate), 2 is a base pattern (unit cell pattern). Broken lines 3 indicate edges of heat fluxes from the unit cells when the fluxes arrive at a heat sink (see Fig. 4), 5 is an edge of the base pattern 2, and lines 6 are perpendicular lines through the centres of base edges 5.

Throughout the Figures hereinafter the same reference numerals designate the same or similar parts.

As shown in Fig. 6, base patterns 5 along one line are placed a half pitch off from the base patterns of each neighbouring line of base patterns. This arrangement is called a "zig-zag pattern". The reason for the use of this term can be understood easily from a comparison with the previous base pattern of Fig. 5.

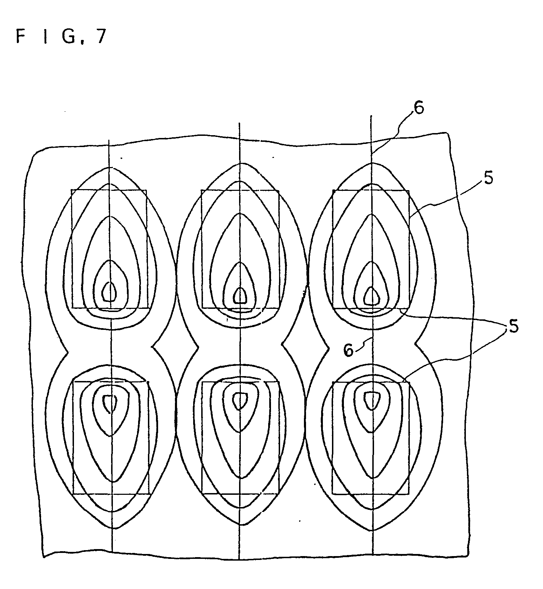

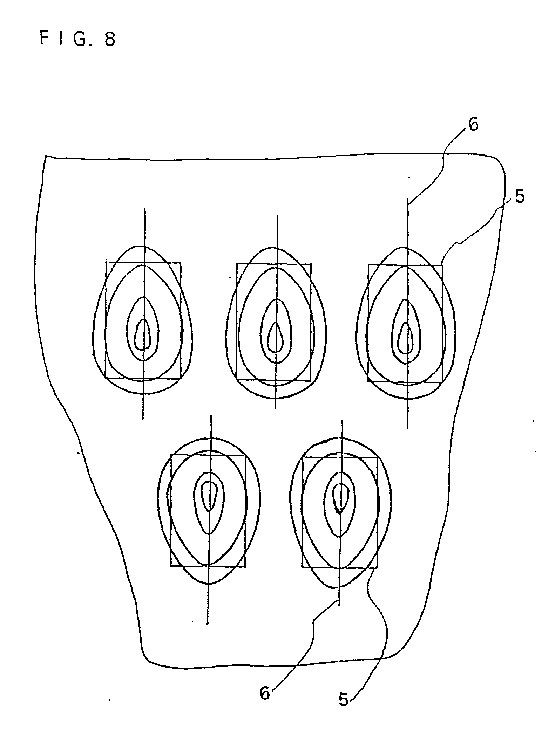

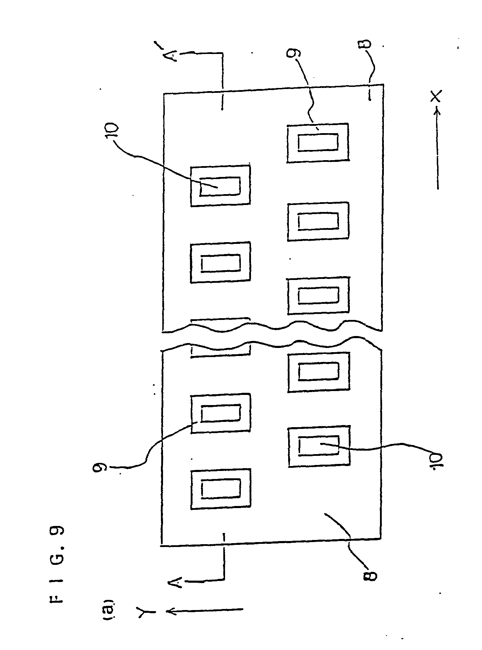

The effect of using the zig-zag pattern can be seen by comparing Figs. 7 and 8, which show constant temperature contours for the orthogonal matrix pattern of Fig. 5 and the zig-zag pattern of Fig. 6 respectively. The measurement of the contours was carried out using an infrared microscope.

Fig. 7 shows thermal distribution for the ordinary base patterns previously used (the orthogonal matrix as shown in Fig. 5) and it can be seen that the contours of constant temperature are deformed and that heat flux of one pattern overlaps that of a neighbouring pattern. This means that the temperature of one base region is increased by the heat generated by its neighbouring base regions (unit patterns) and thus more readily produces hot spots, so that input power which can be supplied to the transistor chip is limited. Thus, the chip cannot be expected to provide more than the output power dictated by this limit.

Thermal distribution for the embodiment of the present invention of Fig. 6 is shown in Fig. 8. The unit cells provide the same output power level as was the case for the purposes of Fig. 7, but thermal distribution is improved to a greater extent; that is, the contours of constant temperature of neighbouring patterns are separated from one another. Therefore, increased input power can be supplied to the chip until the contours of neighbouring patterns do contact each other. The symmetry of the thermal distribution on a unit cell signifies sensitively the state of current flow in it.

It will be noticed that the pitches of the base pattern (unit pattern) are the same in Figs. 5 and 6; therefore the packing densities of unit patterns is equal for the two cases.

It can be considered that the effect of the zig-zag pattern according to the present invention in relation to the improvement provided for the temperature distribution of unit cells arises from the fact that the influence of heat flow from neighbouring unit cells at angles outside the thermal spreading angle mentioned above is avoided. As heat flux density along the edge of a unit cell is largest at the center of a side edge 5 when the unit cell is square in shape, the overlap zone of heat fluxes from different cells can be reduced by moving the perpendicular to the center of the side edge 5 off to the side of that of a neighbouring facing side edge 5 so that the perpendicular 6 does not coincide with that of the neighbouring pattern. This effect can be observed even in the case of a transistor having a base pattern whose pitch is greater than the length ($D_0$) calculated from the thermal spreading angle mentioned above.

With the zig-zag arrangement of unit cells according to the present invention, the lead pattern for a base region is increased only slightly in length (approximately the length of the half pitch), so increases in parasitic capacitance and inductance ware negligible.

However, speaking precisely, packing density with the zig-zag pattern will be decreased at the periphery of the chip. Nevertheless, this does not lead to a real decrease in packing density, because the space so produced at the edge of the transistor chip can be used as handling space or monitoring space which must necessarily be provided in any event for fabrication or for test of the transistor chip.

Fig. 9 illustrates pattern and construction of a bipolar transistor chip embodying the present invention, having a zig-zag base pattern in accordance with the present invention, which produces C.W. output power of 50 Watts(W) at 915 MHz. The bipolar transistor chip has twenty-four unit cells arranged in two lines (the upper line in Fig. 9 will be called the first line and the lower line will be called the second line hereinafter), each line having twelve unit cells. The unit cells of the first line are arranged a half a pitch off from the unit cells of the second line, to form the zig-zag pattern as shown in Fig. 9.

Fig. 9(a) is a plan view of the bipolar transistor chip. In this Figure, 8 is a common collector region formed of a silicon epitaxial layer, 9 is a base region (unit cell) fabricated in the silicon epitaxial layer by diffusion. Base region 9 is of different conductivity type to the collector region 8, and has a size of 150 μm width and 250 μm length. The first and second lines of base regions (unit patterns) are spaced differently from the outer edge of the collector region 8 in the Y-direction. The space between the left edge of the collector region 8 and the left edge of the left most base region 9 is 100 µm in the first line and 225 µm in the second line because of the zig-zag arrangement. Similarly the space between the right edge of the collector region 8 and the right edge of the right most base region 9 is 225 µm in the first line and 100 µm in the second line. The space between the adjacent unit patterns both in X and Y directions is 100 µm. 10 is an emitter region having the same conductivity type as the collector region, fabricated on a base region 9 by diffusion technology.

An emitter region 10 may be shaped as shown in Fig. 9(b1), which illustrates in overview the pattern of the emitter region. Fig. 9(b2) is a cross-sectional view along the line B—B' in Fig. 9(b1). An emitter region as seen in Fig. 9(b1) is called a mesh emitter. This mesh emitter is more efficient for a high frequency transistor, as compared with a parallel rectangular type emitter such as is illustrated in Figs. 9(c1) and (c2), which gives an overview of the pattern and a cross-sectional view along the line C—C' of Fig. 9(c1) respectively, because the periphery of the mesh emitter is longer than that of the parallel rectangular emitter. Reference numeral 30 in Figs. 9(b1), 9(c1), or 9(c2) indicates elemental cells which are surrounded by broken lines.

For the mesh emitter the pitch of the mesh was actually 12 µm and 7 µm respectively in X and Y directions, and the width of the mesh was 1.5 µm. More information about mesh transistors is disclosed for example by M. Fukuta, et al., in Proc. IEEE (Letters) Vol. 56, pp 742, 1968.

Fig. 10 is a cross sectional view taken along the arrowed line A—A' in Fig. 9(a). In Fig. 10, 7 is a silicon substrate, and other reference numerals designate corresponding parts seen in Fig. 9(a). In Fig. 10, the structure of the mesh emitter is now shown, because the emitter structure is not the direct concern of the present invention. The thickness of the silicon substrate 7 is 30 µm, the thickness of the collector region 8 is 10 µm, and the depth of a base region 9 is 200 nm (2,000 Å).

With regard to Figs. 9 and 10, a surface passivation layer of the chip, and wiring patterns which are fabricated on the surface of the chip, are omitted for the sake of simplicity.

Fig. 11 is a sectional view illustrating a bipolar transistor using the chip of Fig. 10. In Fig. 11, 11 is a silver (Ag) layer about 20 µm thick for soldering the chip to a heat sink 12. The heat sink 12 is made of beryllium oxide (BeO) and is 1,000 µm thick, 7,000 µm widem and 4,000 µm long. Therefore, the size of heat sink 12 is sufficiently larger than that of silicon substrate 7 or collector region 8. 13 is a second heat sink made of copper (Cu) being 1,500 µm thick, 40,000 µm wide and 15,000 µm long. Therefore, the size of the second sink 13 is sufficiently larger than that of heat sink 12.

The high frequency and high power transistor disclosed above provides approximately 40% power efficiency producing 50 W output power at 915 MHz. The thermal resistance of the transistor chip is 1.0°C/W. On the other hand, the thermal resistance of a previous transistor having an orthogonal matrix arrangement of base patterns is 1.2°C/W. Therefore, it is clear that the present invention can decrease thermal resistance by 0.2°C/W. This corresponds to a decrease of junction temperature of 15°C.

This decrease of 15°C is very important, because, by a decrease of 15°C, the transistor chip is provided with sufficient margin to operate more stably over a longer life, and it becomes possible provide a greater power output if required.

In the graph of Fig. 12 the curves show the relationships between output power and input power at 915 MHz C.W. (continuous wave) operation for high power transistors as previously provided and in accordance with an embodiment of the present invention. The curve joining solid black points corresponds to the output power of a transistor having the orthogonal matrix unit cell arrangement of the previous design. The curve joining hollow circles shows the output power of a transistor which has the zig-zag unit cell arrangement of the present invention. Both transistors were of the mesh emitter type and had the same chip size (1.5 mm×4.75 mm) and the same emitter region and base region patterns, excepting the difference between the orthogonal matrix and zig-zag arrangements.

It will be clear from Fig. 12 that the previous transistor cannot guarantee an output value of 100 W, because some margin is required to ensure reliability. On the other hand, the transistor according to the present invention can provide an output of 100 W. The inventor believes that this is the highest output power attained by a single chip transistor at 915 MHz.

If the transistor chip has more more than three unit cells (lines of unit cells), the zig-zag pattern can be made so that the odd number lines such as 1,3,5, — and the even number lines such as 2,4,6 — are arranged in zig-zag each other (each with respect to its nieghbouring lines).

The present invention can be applied to the arrangement of unit cells even when the shape of the unit cells is other than square. For example, when the shape of the unit cells is triangular and they are arrenged in two lines with sides facing each other, the thermal resistance can be improved by a zig-zag arrangement of the unit cells as shown in Fig. 13. When the unit cells have a hexagonal shape, the zig-zag arrangement of the unit cells as shown in Fig. 14 is very effective to reduce the thermal resistance in the transistor chip.

Rectangular shaped cells or octagonal shaped cells are also possible for example.

Above, description has been given with respect to a bipolar transistor, especially with respect to a mesh emitter transistor. However, it will be clear that the zig-zag arrangement of unit cells can be applied to any type of bipolar transistor, such as a parallel rectangular emitter type transistor. The material used for the transistor is not limited to silicon; it can be any suitable material, such as gallium arsenide.

It will be clear that the present invention requires no change in conventional semiconductor manufacturing prosesses; it can be applied regardless of the fabrication process used for semiconductor devices, to improve the thermal dissipation of the chip.

## Claims

1. A high-power and high-frequency semiconductor device forming a bipolar transistor, comprising:—

a semiconductor substrate (7);

a common collector region (8) formed on a surface of said semiconductor substrate (7), said common collector region (8) having a first conductivity type;

a plurality of base regions (2; 9) operatively connected in paralllel, having a second conductivity type, opposite to the first conductivity type, each of said base regions (2; 9) being formed with a polygon shape (5) on the surface of said semiconductor substrate (7) in said common collector region (8), and

a plurality of emitter regions (10), operatively connected in parallel, having the first conductivity type, at least one of said emitter regions (11) being formed in each of said base regions (2; 9); characterised in that

the base regions (2; 9) are arranged in first and second parallel lines which lie alongside one another, with the base regions (2; 9) spaced apart one from the next at the same pitch in each of those lines, and in that the base regions (2; 9) in the first line are offset from the base regions (2; 9) in the second line.

2. A device as claimed in claim 1, wherein the base regions (2; 9) in the first line are offset by one half of the said pitch from the base regions (2; 9) in the second line.

3. A device as claimed in claim 1 or 2, wherein the polygon shape (5) of each base region (2; 9) is a rectangle.

4. A device as claimed in claim 3, wherein said pitch is 250 micrometers, wherein said first and second lines are 350 micrometers apart, and wherein each of said base regions (2; 9) has a width of 150 micrometers measured parallel to said first and second lines, and a length of 250 micrometers measured perpendicularly to those lines.

5. A device as claimed in claim 1 or 2, wherein the polygon shape of each of said base regions (2; 9) is a square, a triangle, a hexagon or an octagon.

6. A device as claimed in any preceding claim, wherein each of said emitter regions (10) comprises a mesh emitter.

## Patentansprüche

1. Hochleistungs- und Hochfrequenz-Halbleitvorrichtung, die einen bipolaren Transistor bildet, mit:—

einem Halbleitersubstrat (7);

einem gemeinsamen Kollektorbereich (8), der auf einer Oberfläche des genannten Halbleitersubstrats (7) gebildet ist, welcher gemeinsame Kollektorbereich (8) einen ersten Leitfähigheitstyp hat;

einer Vielzahl von wirkungsmäßig parallel verbundenen Basisbereichen (2; 9), die einen zweiten Leitfahigkeitstyp haben, entgegengesetzt zum ersten Leitfahigkeitstyp, wobei jeder der genannten Basisbereiche (2; 9) mit einer polygonen Form (5) auf der Oberfläche des genannten Halbleitersubstrats (7) in dem genannten gemeinsamen Kollektorbereich (8) gebildet ist, und

einer Vielzahl von wirkungsmäßig parallel verbundenen Emitterbereichen (10), de den ersten Leitfahigkeitstyp haben, wobei wenigstens einer der genannten Emitterbereiche (11) in jedem der genannten Basisbereiche (2; 9) gebildet ist; dadurch gekennzeichnet, daß

die Basisbereiche (2; 9) in ersten und zweiten parallelen Reihen angeordnet sind, welche längs nebeneinander liegen, mit den Basisbereichen (2; 9) mit Abstand voneinander mit derselben Teilung in jeder von jenen Reihen angeordnet, und daß die Basisbereiche (2; 9) in der ersten Reihe gegenüber den Basisbereichen (2; 9) in der zweiten Reihe versetzt sind.

2. Vorrichtung nach Anspruch 1, bei der die Basisbereiche (2; 9) in der ersten Reihe um eine Hälfte der genannten Teilung von den Basisbereichen (2; 9) in der zweiten Reihe versetzt sind.

3. Vorrichtung nach Anspruch 1 oder 2, bei der die polygone Form (5) von jedem Basisbereich (2; 9) ein Rechteck ist.

4. Vorrichtung nach Anspruch 3, bei die genannte Teilung 250 Mikrometer beträgt, bei der die ganannten ersten und zweiten Reihen um 350 Mikrometer voneinander entfernt sind,

bei der jeder der genannten Basisbereiche (2; 9) eine Breite von 150 Mikrometern, gemessen parallel zu den genannten ersten und zweiten Reihen, und eine Länge, von 250 Mikrometern, gemessen senkrecht zu jenen Reihen, hat.

5. Vorrichtung nach Anspruch 1 oder 2, bie der die polygone Form von jedem der genannten Basisbereiche (2; 9) ein Quadrat, ein Dreieck, ein Hexagon oder ein Oktagon ist.

6. Vorrichtung nach einem der vorhergehenden Ansprüche, bei der jeder der ganannten Emitterbereiche (10) ein Maschenemitter ist.

## Revendications

1. Un dispositif à semiconducteurs de haute fréquence et de forte puissance formant un transistor bipolaire, comprenant:

un substrat semiconducteur (7);

une région de collecteur commune (8) formée sur une surface du substrat semiconducteur (7), cette région de collecteur commune (8) ayant un premier type de conductivité;

un ensemble de régions de base (2; 9) connectées fonctionnellement en parallèle, ayant en second type de conductivité, opposé au premier type de conductivité, chacune de ces régions de base (2; 9) étant formée avec une forme polygonale (5) sur la surface du substrat semiconducteur (7) dans la région de collecteur commune (8), et

un ensemble de régions d'émetteur (10), connectées fonctionnellement en parallèle, ayant le premier type de conductivité l'une au moins des régions d'émetteur (11) étant formée dans chacune des régions de base (2; 9); caractérisé en ce que

les régions de base (2; 9) sont disposées en une première et une seconde lignes parallèles qui s'étendent l'une à côté de l'autre, avec chacune des régions de base (2; 9) espacée per rapport à la suivante avec le même pas dans chacune de ces lignes, et en ce que les régions de base (2; 9) dans la première ligne sont décalées par rapport aux régions de base (2; 9) dans la seconde ligne.

2. Un dispositif selon la revendication 1, dans lequel les régions de base (2; 9) dans la première ligne sont décalées de la moitié du pas précité par rapport aux régions de base (2; 9) dans le seconde ligne.

3. Un dispositif selon la revendication 1 ou 2, dans lequel la forme polygonale (5) de chaque région de base (2; 9) est un rectangle.

4. Un dispositif selon la revendication 3, dans lequel le pas est de 250 micromètres,

dans lequel les première et seconde lignes sont séparées par une distance de 250 micromètres,

dans lequel chacune des régions de base (2; 9) a une largeur de 150 micromètres, mesurée parallèlement aux première et seconde lignes, et une longueur de 250 micromètres mesurée perpendiculairement à ces lignes.

5. Un dispositif selon la revendication 1 ou 2, dans lequel la forme polygonale de chacune des régions de base (2; 9) est un carré, un triangle, un hexagone, ou un octogone.

6. Un dispositif selon l'une quelconque des revendications précédentes dans lequel chacune des régions d'émetteur (10) consiste en un émetteur en forme de grille.

FIG. 1

(a)

2

50

(b)

2

60

60

2

EP 0 126 611 B1

FIG. 2

FIG. 3

FIG. 4

F I G. 5

F I G. 6

F I G. 7

FIG. 8

F I G. 9

(a)

FIG. 9 contd.

(b1)

(c1)

(b2)

(c2)

EP 0 126 611 B1

F I G. 10

9　10　　　　　　9　10

8

7

F I G. 11

7　　　　　8　11

12

13

FIG. 12

F I G. 1 3

F I G. 1 4